**Europäisches Patentamt**

**European Patent Office**

**Office européen des brevets**

(19)

(11) Veröffentlichungsnummer: **0 043 516**
**B1**

(12)

# EUROPÄISCHE PATENTSCHRIFT

(45) Veröffentlichungstag der Patentschrift:
**12.09.84**

(21) Anmeldenummer: **81104959.2**

(22) Anmeldetag: **26.06.81**

(51) Int. Cl.³: **H 02 M 1/14, H 03 H 7/01**

(54) **Elektrische Filteranordnung.**

(30) Priorität: **08.07.80 SE 8005008**

(43) Veröffentlichungstag der Anmeldung:
**13.01.82 Patentblatt 82/2**

(45) Bekanntmachung des Hinweises auf die Patenterteilung:
**12.09.84 Patentblatt 84/37**

(84) Benannte Vertragsstaaten:
**CH DE FR GB LI**

(56) Entgegenhaltungen:
**US - A - 3 825 814**

(73) Patentinhaber: **ASEA AB, S-721 83 Västeras (SE)**

(72) Erfinder: **Bergdahl, Bernt, Dipl. Ing., Anisstigen 3,
S-771 00 Ludvika (SE)**

(74) Vertreter: **Boecker, Joachim, Dr.-Ing.,
Rathenauplatz 2-8, D-6000 Frankfurt a.M. 1 (DE)**

# Beschreibung

Die Erfindung betrifft eine elektrische Filteranordnung gemäss dem Oberbegriff des Anspruches 1.

Filteranordnungen in elektrischen Starkstromanlagen wie z.B. Oberwellenfilter in Stromrichteranlagen, werden häufig dazu benutzt, um Strom- oder Spannungskomponenten zu reduzieren, die anderenfalls Signal-, Übertragungs- oder Betriebsstörungen in an das Netz angeschlossene Objekte verursachen würden. In diesen Fällen ist es sehr wichtig, dass das Filter immer einwandfrei arbeitet. Bei schmalbandigen Filtern kann bereits eine kleine Veränderung der Reaktanz eines zu dem Filter gehörenden Schaltungselementes zu einer erheblichen Verschlechterung der Funktion des Filters führen. Eine solche Veränderung kann beispielsweise leicht durch einen Fehler in einem Kondensator verursacht werden.

Der Erfindung liegt die Aufgabe zugrunde, eine elektrische Filteranordnung der eingangs genannten Art zu entwickeln, bei welcher eine Verschlechterung der Funktion des Filters angezeigt wird, so dass unmittelbar geeignete Gegenmassnahmen ergriffen werden können.

Zur Lösung dieser Aufgabe wird eine elektrische Filteranordnung der eingangs genannten Art vorgeschlagen, die erfindungsgemäss die im kennzeichnenden Teil des Anspruches 1 genannten Merkmale hat.

Vorteilhafte Weiterbildungen der Erfindung sind in den Unteransprüchen genannt.

Anhand der in den Figuren gezeigten Ausführungsbeispiele soll die Erfindung näher erläutert werden. Es zeigen

Figur 1 eine Filteranordnung gemäss der Erfindung in einer Stromrichteranlage für eine Hochspannungsgleichstromübertragung,

Figur 2 eine Anordnung zur Änderung der Kapazitäten des Modellfilters zur Kompensation von temperaturabhängigen Änderungen der Kapazitäten des Hauptfilters.

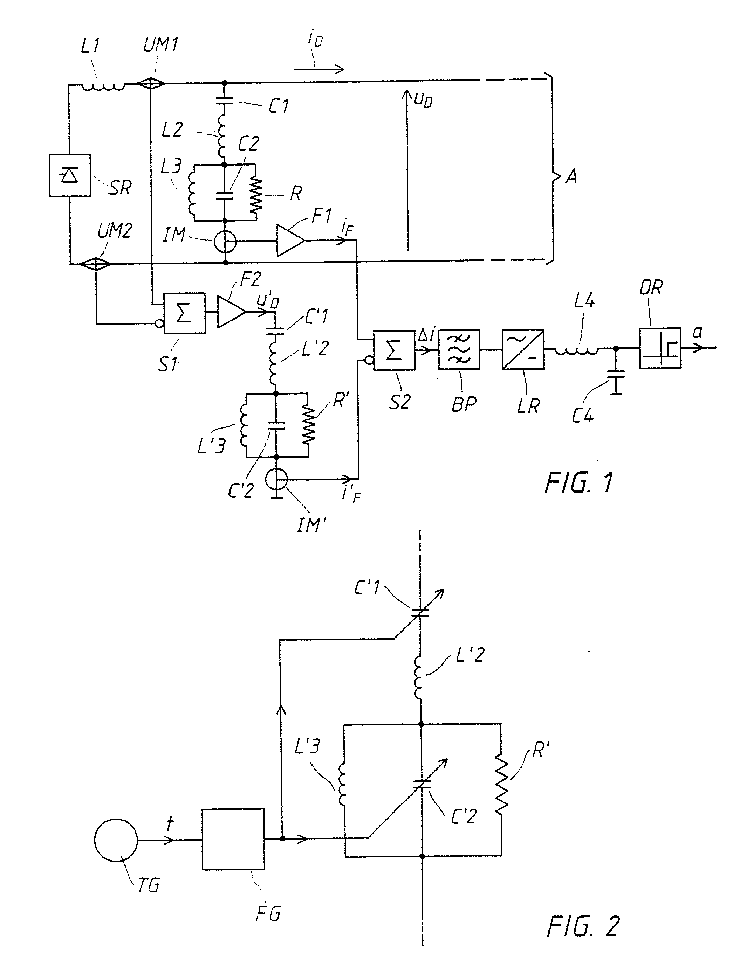

Figur 1 zeigt einen Stromrichter SR, der an eine Gleichstromleitung A zur Leistungsübertragung mit Hilfe von hochgespanntem Gleichstrom angeschlossen ist. Der Strom der Leitung ist mit $i_D$ und die Spannung mit $U_D$ bezeichnet. Die Leiung ist auf bekannte Weise mit einer Glättungsinduktivität L1 und einem Oberwellenfilter C1, C2, L2, L3, R versehen, das auf eine oder mehrere bestimmte Oberwellen des Stromrichters abgestimmt ist. Das Filter besteht aus den Kondensatoren C1 und C2, den Induktivitäten L2 und L3 und dem Widerstand R. Zur Überwachung der Funktion des Filters ist ein Modellfilter vorgesehen. Dieses besteht aus den Kondensatoren C'1 und C'2, den Induktivitäten L'2 und L'3 und dem Widerstand R' und ist so ausgebildet, dass es dieselbe Frequenzcharakteristik wie das Hauptfilter C1, C2, L2, L3, R hat. Das Modellfilter ist für geringe Leistung ausgelegt und zweckmässig aus konventionellen Elektronikschaltungselementen des Niedrigleistungstyps aufgebaut.

An jeden der beiden Leiter der Übertragungsleitung A ist ein Spannungsmessgerät UM1 bzw. UM2 angeschlossen, das beispielsweise als kapazitiver Spannungsteiler aufgebaut sein kann, dessen Ausgangssignal dem Augenblickswert der Leiterspannung gegen Erde proportional ist. Die Differenz der beiden Ausgangssignale der beiden Messgeräte wird in einem Summierungsglied S1 gebildet, dessen Ausgangssignal dem Augenblickswert der Leitungsspannung $u_D$ proportional ist. Dieses Ausgangssignal wird in einem Verstärker F2 auf ein zweckmässiges Leistungs- und Spannungsniveau (z.B. einige Dekaden Volt) übergeführt und dem Modellfilter zur Speisung zugeführt. Das verstärkte Signal wird mit $u'_D$ bezeichnet und bildet die Leitungsspannung $u_D$ ab.

Ein Strommessgerät IM dient zur Messung des das Hauptfilter durchfliessenden Stromes und liefert über einen Verstärker F1 ein dem Filterstrom entsprechendes Signal $i_F$. An der entsprechenden Stelle im Modellfilter ist ein Strommessgerät IM' zur Messung des das Modellfilter durchfliessenden Stroms $i'_F$ angeordnet. Die Verstärkung des Verstärkers F2 ist so bemessen, dass der Hauptfilterstrom in demselben Massstab abgebildet wird wie der Modellfilterstrom, d.h. so, dass bei einem fehlerfreien Hauptfilter $i_F = i'_F$ ist. Die beiden Strommessignale $i_F$ und $i'_F$ werden einem Summierungsglied S2 zugeführt, dessen Ausgangssignal $\triangle$ i ein Mass für die Differenz $i_F - i'_F$ ist. Das Signal $\triangle$ wird über ein Bandpassfilter BP einem Gleichrichter LR zugeführt. Das Filter BP lässt Signale mit der Frequenz oder den Frequenzen durch, auf welche Haupt- und Modellfilter abgestimmt sind. Das Ausgangssignal des Gleichrichters LR wird einem Niveaudiskriminator DR zugeführt, der ein Anzeigesignal a gibt, wenn die Differenz $i_F - i'_F$ ein vorbestimmtes Niveau überschreitet. Vor dem Diskriminator DR liegt ein Glättungs- oder Verzögerungsglied L4 - C4, um das Auftreten eines Anzeigesignals als Folge von Ausgleichsvorgängen (Transienten) und kurzzeitigen Störungen zu verhindern.

Ein Hauptfilter der in Figur 1 gezeigten Art ist normalerweise im Freien aufgestellt und daher starken Temperaturschwankungen ausgesetzt, die ihrerseits Änderungen der Impedanzen der das Filter bildenden Schaltungselemente verursachen, beispielsweise der Kapazitätswerke der Filterkondensatoren. Dies kann zu unbegründeten Anzeigesignalen führen. Um dieses zu verhindern, ist gemäss Figur 2 ein Temperaturgeber TG vorgesehen, der die Aussentemperatur an den Kondensatoren des Hauptfilters erfasst. Das Ausgangssignal t des Gebers wird einem Funktionsgeber FG zugeführt, dessen Ausganggsignal die Kapazität der Kondensatoren C'1 und C'2 des Modellfilters steuert. Der Funktionsgeber ist so ausgebildet, dass die Temperaturabhängigkeit des Hauptfilters kompensiert wird, also die Frequenzcharakteristik mit der des Hauptfilters auch bei starken Temperaturschwankungen übereinstimmt.

Die Erfindung kann auch für andere als die genannten Anwendungsbereiche und auch bei anderen als den beschriebenen Filterarten verwendet werden. Wenn mehrere Filter in einer Anlage angeordnet werden, beispielsweise in einem Hochspannungsstromrichter nach Figur 1, kann jedes Filter zweckmässig mit einem Modellfilter und einer Anzeigeanordnung der in Figur 1 gezeigten Art versehen werden.

Die Erfassung des Stroms im Haupt- und Modellfilter kann auf andere als der in Figur 1 gezeigten Weise vorgenommen werden. Für das Prinzip der Erfindung ist es nicht notwendig, den Gesamtstrom der Filter zu erfassen wie dies in Figur 1 gezeigt ist. Es kann auch der Strom in jedem beliebigen Zweig, in welchen bei typischen Fehlern im Filter eine Stromänderung auftritt, erfasst werden.

In Figur 1 wurde gezeigt, wie zum Vergleich der Ströme des Haupt- und Modellfilters die Differenz zwischen diesen Strömen gebildet wird. Alternativ kann dieser Vergleich auch durch Quotientenbildung oder auf andere Weise durchgeführt werden. In Figur 1 erfolgt der Vergleich der beiden Ströme anhand ihrer Amplituden. Der Vergleich kann alternativ jedoch auch anhand der Phasenlagen der Ströme des Haupt- und Modellfilters oder auf andere Weise vorgenommen werden.

Das in Figur 1 gezeigte Bandpassfilter BP kann durch zwei vor dem Summierungsglied S2 liegenden Bandpassfilter ersetzt oder eventuell ganz fortgelassen werden.

Das Anzeigesignal a kann zur Beseitigung eines Alarmgebers benutzt werden, wenn die Funktion des Hauptfilters herabgesetzt ist, und bei Verwendung mehrerer Filter kann es benutzt werden, das defekte Filter zu bezeichnen. Hierbei können manuell ausführbare Massnahmen ergriffen werden, wie z.B. das Fortschalten des Filters oder die Justierung der Filterabstimmung. Es ist auch möglich, dass das von der Anordnung nach der Erfindung gelieferte Signal dazu verwendet wird, automatisch eine Justierung der Filterabstimmung vorzunehmen, beispielsweise durch Zu- und Abschalten von Kondensatorelementen.

**Patentansprüche:**

1. Elektrische Filteranordnung, vorzugsweise eine Anordnung zur Oberwellenfiltrierung in einer Stromrichteranlage, dadurch gekennzeichnet, dass ein Hauptfilter (C1, C2, L2, L3, R) und ein Modellfilter (C'1, C'2, L'2, L'3, R') mit derselben Frequenzcharakteristik wie das Hauptfilter vorhanden sind, dass Glieder (UM1, UM2, S1, F2) zur Speisung des Modellfilters mit einer der am Hauptfilter liegenden Spannung ($u_D$) entsprechenden Spannung ($u'_D$) vorhanden sind, dass stromerfassende Glieder (IM, IM') vorhanden sind, die einen im Hauptfilter fliessenden Strom ($i_F$) und den entsprechenden Strom ($i'_F$) im Modellfilter erfassen, und dass der vergleichende Glieder (S2, BP, LR, L4, C4, DR) vorhanden sind, die in Abhängigkeit von einer Abweichung zwischen den beiden genannten Strömen ein Anzeigesignal (a) zur Anzeige des Betriebszustandes der Filteranordnung abgeben.

2. Filteranordnung nach Anspruch 1, dadurch gekennzeichnet, dass das Modellfilter für eine im Verhältnis zum Hauptfilter geringe Leistung ausgelegt ist.

3. Filteranordnung nach Anspruch 1 oder 2, dadurch gekennzeichnet, dass Glieder (F1) vorhanden sind zur Umwandlung mindestens des einen Signals der stromerfassenden Glieder derart, dass diese Signale ($i_F$, $i'_F$) bei ungestörtem Betrieb gleich sind.

4. Filteranordnung nach einem der vorhergehenden Ansprüche, dadurch gekennzeichnet, dass die vergleichenden Glieder das Anzeigesignal in Abhängigkeit der Differenz der Signale der beiden stromerfassenden Glieder bilden.

5. Filteranordnung nach einem der vorhergehenden Ansprüche, bei welcher das Hauptfilter und das Modellfilter auf einen bestimmten Frequenzbereich abgestimmt sind, dadurch gekennzeichnet, dass Bandpassfilter (BP) zur Filtrierung der Signale der stromerfassenden Glieder vorhanden sind, die Signale ausserhalb des genannten Frequenzbereiches sperren.

6. Filteranordnung nach einem der vorhergehenden Ansprüche, bei welcher das Hauptfilter einen Kondensator (z.B. C1) enthält, dadurch gekennzeichnet, dass Glieder (TG, FG) vorhanden sind, welche die Kapazität des entsprechenden Kondensators (C'1) des Modellfilters derart in Abhängigkeit einer am Kondensator des Hauptfilters gemessenen Temperatur (t) ändern, dass die Temperaturabhängigkeit des Kondensators des Hauptfilters kompensiert wird.

**Revendications**

1. Dispositif électrique de filtrage, de préférence dispositif pour filtrer les harmoniques dans un montage convertisseur, caractérisé par le fait qu'il est prévu un filtre principal (C1, C2, L2, L3, R) et un filtre de référence (C'1, C'2, L'2, L'3, R) ayant la même courbe caractéristique de fréquence que le filtre principal, qu'il est prévu deux éléments (UM1, UM2, S1, F2) pour l'alimentation du filtre de référence avec une tension ($u'_D$) qui correspond à la tension ($u_D$) appliquée au filtre principal, qu'il est prévu des éléments (IM, IM') de saisie du courant, aptes à saisir le courant ($i_F$) passant par le filtre principal et le courant correspondant ($i_F$) dans le filtre de référence, et qu'il est prévu des éléments comparateurs (S2, BP, LR, L4, C4, DR) qui, en fonction de l'écart entre les deux courants mentionnés ci-dessus, émettent un signal de sortie (a) pour indiquer l'état de fonctionnement du dispositif électrique de filtrage.

2. Dispositif électrique de filtrage selon la revendication 1, caractérisé par le fait que le filtre de référence est conçu pour une puissance faible comparativement au filtre principal.

3. Dispositif électrique de filtrage selon la revendication 1 ou 2, caractérisé par le fait qu'il est prévu des éléments (F1) servant à convertir au moins l'un des signaux des éléments de saisie du courant, de manière que ces signaux ($i_F$, $i'_F$) soient égaux en fonctionnement non pertubé.

4. Dispositif électrique de filtrage selon l'une des revendications précédentes, caractérisé par le fait que des éléments comparateurs forment le signal d'indication en fonction de la distance des signaux des deux éléments de saisie des courants.

5. Dispositif électrique de filtrage selon l'une des revendications précédentes, dans lequel le filtre principal et le filtre de référence sont accordés sur une plage déterminée de fréquences, caractérisé par le fait qu'il est prévu des filtres passe-bande (BP) pour filtrer les signaux des éléments de saisie des courants, et qui bloquent les signaux en déhors de ladite plage de fréquence.

6. Dispositif électrique de filtrage selon l'une des revendications précédentes, dans lequel le filtre principal comporte un condensator (par exemple C1), caractérisé par le fait qu'il est prévu des éléments (TG, FG) qui modifient la capacité du condensateur correspondant (C'1) du filtre de référence de telle façon en fonction d'une température (t) mesurée au niveau du condensateur du filtre principal, que la dépendance, par rapport à la température, du condensateur du filtre principal est compensée.

## Claims

1. Electric Filter device, preferably a device for filtering of harmonics in a converter plant, characterized in that it comprises a main filter (C1, C2, L2, L3, R) and a model filter (C'1, C'2, L'2, L'3, R') with the same frequency characteristic as the main filter, that it comprises elements (UM1, UM2, S1, F2) for supplying the model filter with a voltage ($u'_D$) corresponding to the voltage ($u_D$) across the main filter, that it comprises current-sensing elements (IM, IM') sensing the current ($i_F$) flowing through the main filter and the corresponding current ($i'_F$) flowing through the model filter, and that it comprises comparision elements (S2, BP, LR, L4, C4, DR), delivering an indicating signal (a) in dependance on the deviation between said two currents to indicate the operating state of the filter device.

2. Filter device according to claim 1, characterized in that the model filter is dimensioned for a power rate small in comparison with the power rate of the main filter.

3. Filter device according to claim 1 or 2, characterized in that it comprises elements (F1) for altering at least one of the signals from the current-sensing elements in such a way that these signals ($i_F$, $i'_F$) are equal during undisturbed operation.

4. Filter device according to any of the preceding claims, characterized in that the comparision elements are arranged to form the indicating signal in dependence on the difference between the signals from the two current-sensing elements.

5. Filter device according to any of the preceding claims, in which the main filter and the model filter are tuned to a certain frequency range, characerized in that it comprises band pass filters (BP) for filtering the signals from the current-sensing elements, which bend pass filters (BP) block signals outside said frequency range.

6. Filter device according to any of the preceding claims, in which the man filter comprises a capacitor (e.g. C1), characterized in that it comprises elements (TG, FG) for varying the capacitance of the corresponding capacitor (C'1) of the model filter in dependance on a temperature (t) measured at the capacitor of the main filter in such a way that the temperature dependence of the capacitor of the main filter is compensated.

FIG. 1

FIG. 2

5